(19) Europäisches Patentamt
European Patent Office
Office européen des brevets

(11) **EP 3 560 054 B1**

(12) **EUROPEAN PATENT SPECIFICATION**

(45) Date of publication and mention
of the grant of the patent:
**01.09.2021 Bulletin 2021/35**

(51) Int Cl.:
*H02H 1/00* *(2006.01)*      *G01R 15/18* *(2006.01)*
*H02H 3/28* *(2006.01)*      *H02H 7/045* *(2006.01)*
*H02H 1/04* *(2006.01)*

(21) Application number: **17762209.9**

(22) Date of filing: **31.07.2017**

(86) International application number:
**PCT/IB2017/054658**

(87) International publication number:
**WO 2018/122632 (05.07.2018 Gazette 2018/27)**

(54) **A METHOD FOR DETECTING INRUSH AND CT SATURATION AND AN INTELLIGENT ELECTRONIC DEVICE THEREFOR**

VERFAHREN ZUR ERKENNUNG VON ZUSTROM UND STROMWANDLERSÄTTIGUNG SOWIE INTELLIGENTE ELEKTRONISCHE VORRICHTUNG DAFÜR

PROCÉDÉ DE DÉTECTION D'APPEL DE COURANT ET DE SATURATION D'UN TRANSFORMATEUR DE COURANT ET DISPOSITIF ÉLECTRONIQUE INTELLIGENT ASSOCIÉ

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **26.12.2016 IN 201641044243**

(43) Date of publication of application:
**30.10.2019 Bulletin 2019/44**

(73) Proprietor: **ABB Schweiz AG**
**5400 Baden (CH)**

(72) Inventors:
• **VALSAN, Simi**
**Thottakkattukara 683108 (IN)**
• **GUPTA, Arinjai**
**Bangalore 560093 (IN)**

(74) Representative: **Zimmermann & Partner**
**Patentanwälte mbB**
**Postfach 330 920**
**80069 München (DE)**

(56) References cited:
**WO-A1-93/13581          US-A- 6 072 310**
**US-A1- 2005 094 344      US-A1- 2011 241 654**
**US-B1- 6 442 010**

**Description**

**FIELD OF THE INVENTION**

The present invention relates generally to the field of protection of power systems and more particularly to a method for detecting an inrush condition and saturation in a current transformer during inrush condition an intelligent electronic device thereof.

**BACKGROUND OF THE INVENTION**

In a power system, when a power transformer is energized a transient current may be drawn initially by the power transformer. This transient current drawn initially by the power transformer is also known as an inrush current. The inrush current lasts for a short duration however it can cause damage to power systems due to its high magnitude.

Usually, a differential scheme is employed to protect a transformer which effectively monitors the primary currents and secondary currents. If the difference between appropriately scaled currents on primary and secondary exceeds a set threshold, a protective relay acts to isolate the transformer. During transformer faults, the primary and scaled secondary currents will have a large difference causing the differential relay to act. The actual high currents flowing in the transformer are transformed to lower levels to make them suitable for observation by any differential protection equipment. A Current Transformer (CT) is used for this transformation which supplies information to the differential relays. These CTs mostly have iron cores and during faults or inrush, the magnetic flux induced is very high causing the core to saturate. Due to this reason distorted current information is received by the relays. Additionally, when inrush condition occurs during transformer energization, since the difference in the currents on the primary and secondary sides are quite high, the differential protection schemes may malfunction mistaking an inrush condition to be a transformer fault.

Conventionally, restrain during an inrush condition by the protection relays in based on second harmonic content present in the current. But in practice, some amount of second harmonic content can be present during faults. Also, the advances in material research has resulted in better cores which exhibits lesser second harmonic content during an inrush condition. Further, if CT saturates during the inrush condition, the conventional restrain mechanisms may fail which may in turn enable the protective relays to act unintendedly. Detection of CT saturation during inrush also provides an insight into the health of the CT.

Hence, in light of the above drawbacks there lies a need for detecting inrush current in a reliable and fast manner as well as identifying CT saturation occurred during the inrush condition.

Document US 2005/094344 A1 describes a method of compensating for the distorted secondary current of a current transformer.

Document US 2011/241654 A1 describes a method and an apparatus for dynamic signal switching with multiple measurement sources, for a merging unit in an electrical power system, said merging unit receiving at least two input signals from at least one current transformer measuring the same physical primary quantity.

Document WO 93/13581 A1 describes a numerical method which via discrete-time measurements of the secondary current (is(k)) from a current transformer reconstructs the primary current (ipr(k)) and the secondary current (isr(k)) of a saturated current transformer, which takes place in a block B1 and a method for detecting saturation as well as for detecting when saturation ceases, which takes place in blocks B2, B3, B4, B5, B6 and B7.

Document US 6,072,310 describes a method and a device for detecting and correcting a saturated current profile of a current transformer in a particularly simple and reliable way, initially uses a number of logic inquiries derived from sampled values of the present current signal profile to detect a start of saturation on the basis of a pattern recognition.

Document US 6,442,010 (B1) a differential protective relay and method for a microprocessor-based bus differential protective relay that ensures fast and sensitive operation under internal fault conditions and offers improved stability during external fault and other non-internal fault conditions.

**SUMMARY**

The above-mentioned shortcomings, disadvantages and problems are addressed herein which will be understood by reading and understanding the following specification.

In one aspect, the present invention provides a method for detecting inrush as well as saturation in a current transformer occurring during inrush with an intelligent electronic device (IED), wherein the IED is coupled to the current transformer and the current transformer is connected for measurement of current in a circuit having an electrical equipment protected by the IED, the method steps being performed in the IED, the method comprising: acquiring a current signal from the current transformer and converting the current signal into sampled values; computing an estimated sampled value of the current signal at a first time instance using the sampled values of the current signal; determining an error by obtaining difference between the estimated sampled value of the current signal at the first time instance and a sampled value of current signal at the first time instance from the sampled values; comparing the error to a first threshold value to identify a deviation in the sampled value of the current signal and a second time instance corresponding to the inception of deviation; applying wavelet filtering on the sampled values occurring after the second time instance to obtain one or more frequency contents occurring in the sampled value occurring after the inception of deviation; comparing the one or more obtained frequency contents with a second threshold to detect an inrush condition at a third time instance; computing rate of change in the sampled values occurring between the inception of deviation and the detected inrush condition; and detecting a saturation in the current transformer on exceeding a predefined third threshold value by the computed rate of change in the sampled values.

In an embodiment, computing an estimated sampled value of the current signal comprises applying regression using a plurality of pre-calculated regression coefficients.

In an embodiment, the plurality of predetermined regression coefficients are estimated based on a unit sine wave at a sampling frequency of the CT output.

In an embodiment, the first threshold is at least one of a predefined first threshold and the deviation is identified when the error exceeds the first threshold.

In an embodiment, the second threshold is at least one of a predefined second threshold to detect the inrush condition.

In an embodiment, the wavelet filtering is done using a finite impulse response high pass filter having predefined wavelet coefficients.

In an embodiment, the third threshold is at least one of a predefined third threshold to detect the saturation in the current transformer.

In an embodiment, the method described herein above further comprises resetting the detected inrush condition signal subsequent to a predefined number of current signals when the error is less than or equal to the first threshold.

In another aspect of the invention, the present invention provides an Intelligent Electronic Device (IED) with an Inrush condition and CT saturation detection module, wherein the IED is coupled to a current transformer and the current transformer is connected for measurement of current in a circuit having an electrical equipment protected by the IED, the Inrush condition and CT saturation detection module comprising, an analog to digital converter to convert the received current signal from the CT into sampled values of current, a deviation identification module to compute an estimated sampled value of the current signal at a first time instance using the sampled values of the current signal, determine an error by obtaining difference between the estimated sampled value of the current signal at the first time instance and a sampled value of current signal at the first time instance from the sampled values and compare the error to a first threshold value to identify a deviation in the sampled value of the current signal and a second time instance corresponding to an inception of the deviation; a wavelet filtering module to apply wavelet filtering wavelet filtering on the sampled values occurring after the second time instance to obtain one or more frequency contents occurring in the sampled value occurring after the inception of deviation; an inrush detection module to compare the one or more obtained frequency contents with a second threshold to detect an inrush condition at a third time instance; and a CT saturation detection module to compute rate of change in the sampled values occurring between the inception of deviation and the detected inrush condition and detect a saturation in the current transformer on exceeding a predefined third threshold value by the computed rate of change in the sampled values.

In another embodiment, a protection logic to receive the output from the Inrush detection module and CT saturation detection module.

**BRIEF DESCRIPTION OF DRAWINGS**

Figure 1 illustrates a block diagram representation of an intelligent electronic device (IED);

Figure 2 illustrates a method for detection of inrush condition and saturation in a current transformer during inrush condition;

Figure 3 illustrates output waveform representation of CT output for a three phase system and a graph indicating high inrush condition and low CT saturation in all the three phases;

Figure 4 illustrates output waveform representation of CT output for a three phase system and a graph indicating high inrush condition in all three phases and high CT saturation in two of the phases; and

Figure 5 illustrates a graph representing frequency contents present during an inrush condition.

**DETAILED DESCRIPTION**

The present invention is related to a method for detecting inrush condition in a fast and reliable manner as well as detect current transformer saturation during inrush condition. The steps of the method are being performed by a computing/processing device such as an intelligent electronic device (IED). IEDs are commonly used for control or protection functions in electrical networks. The present invention employs multi-resolution analysis to extract information from input current samples to establish an occurrence of inrush. Further, the saturation of current transformer during inrush is detected by analyzing the current for cases in which inrush is being detected for a current cycle.

The method for this invention uses wavelet transform to extract significant information from the current waveform obtained from a CT. Initially, the method detects any deviation or disturbance in the current signal obtained from the secondary of a current measuring transformer and applies auto-regression techniques to obtain an estimated or predicted value of current. The estimated value of current may be obtained in various methods known in the art apart from the disclosed auto-regression analysis. Secondly, if a deviation is detected based on difference in value for the estimated value of the current and the actual current the method applies a single level of decomposition using a basic low order wavelet to extract high frequency detail coefficients. The values of detail coefficients are compared with pre-determined threshold value which is a near zero value to confirm an occurrence of inrush. Finally, rate of change or slope of the current waveform at the point of inrush detection is taken into consideration to confirm the occurrence of CT saturation. The output information regarding inrush condition and CT saturation during inrush can be used for protection function or any other function in the electrical network.

In the following detailed description, reference is made to the accompanying drawings that form a part hereof, and in which is shown by way of illustration specific embodiments, which may be practiced. These embodiments are described in sufficient detail to enable those skilled in the art to practice the embodiments, and it is to be understood that other embodiments may be utilized. The following detailed description is, therefore, not to be taken in a limiting sense.

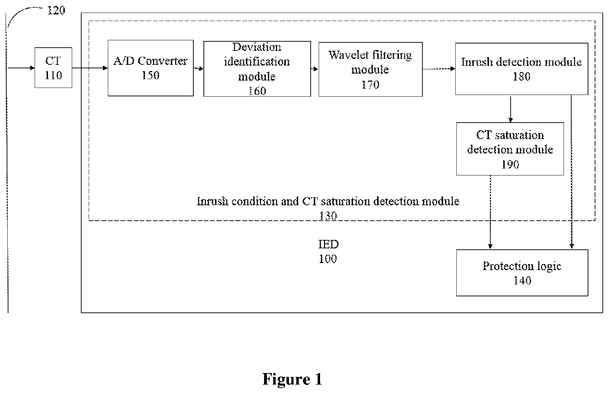

Figure 1 illustrates a block diagram representation of an intelligent electronic device (IED) 100 with a module for detection of inrush condition and CT saturation during inrush condition. The IED 100 is coupled to the current transformer (CT) 110 and the CT 110 is connected for measurement of current in a circuit having an electrical equipment protected by the IED 100. The current transformer (CT) 110 may receive current from any power source indicated by 120. The IED 100 comprises the Inrush condition and CT saturation detection module 130 the output of which is provided to the Protection logic 140 for further action. The inrush condition and CT saturation detection module 130 comprises an A/D converter 150 that receives input from the CT 110, the deviation identification module 160, the wavelet filtering module 170, Inrush detection module 180 and CT saturation detection module 190.

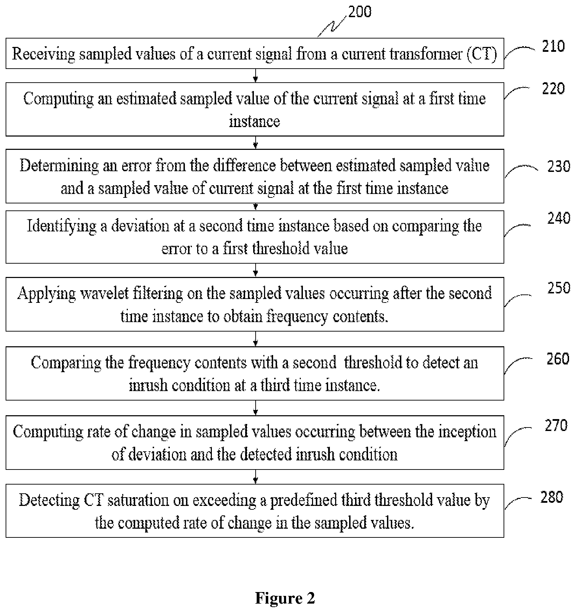

Figure 2 illustrates a method 200 for detecting an inrush condition and detection of CT saturation during the inrush condition. The method is being performed in the IED 100 by the inrush condition and CT saturation during inrush detection module 130. The Analog to Digital converter 150 converts the current signal received from the CT 110 into sampled values of the current signal. In this method 200, step 210 depicts that samples values of current signal are received from the current transformer.

As shown in step 220, the deviation identification module computes an estimated sampled value of the current signal at a first time instance using the sampled values of the current signal. For example any change or disturbance, either due to fault or inrush, can be detected by using auto-regression based techniques. This is done by obtaining the difference between actual and estimated or predicted values of the current. The prediction is based on auto-regression. For exemplary purposes, the present method uses pre-calculated regression coefficients (e.g., C, C1, C2 and C3) which are estimated based on a standard sine waveform of a particular frequency with a known sampling time. Thus the following estimated value of current may be obtained as shown below:

$$\text{Estimated value of current } (n) = C + C1*\text{current}(n-1) + C2*\text{current}(n-2) + C3*\text{current}(n-3)\ldots\ldots\ldots\ldots\ldots\ldots\ldots\ldots\ldots(1)$$

As shown in step 230, an error is determined based on difference between the estimated sampled value of the current signal at the first time instance and a sampled value of current signal at the first time instance from the sampled values. As shown in step 240, a deviation is identified at a second time instance based on comparing the error to a first threshold value. If the estimated current exceeds the actual current by a pre-defined threshold value or the first threshold value, it is detected as deviation or disturbance.

As shown in step 250, the wavelet filtering module applies wavelet filtering on the sampled values occurring after the second time instance to obtain one or more frequency contents occurring in the sampled value occurring after the inception of deviation. When a deviation is detected in the current waveform based on the previous step, wavelet filtering is applied to the current samples to obtain the frequency contents or detail coefficients. An exemplary calculation step is shown assuming the Daubechies db2 wavelet high pass filter.

$$detail\_coeff(n) = abs(WT\_coeff(1)*current(n) + WT\_coeff(2)*current(n-1) +$$

$$WT\_coeff(3)*current(n-2) + WT\_coeff(4)*current(n-3)\ldots\ldots\ldots\ldots\ldots\ldots\ldots(2)$$

It may be known to the person skilled in the art that, any other suitable wavelet can be chosen to extract the information in a similar way.

As shown in step 260, the one or more obtained frequency contents or detail coefficient are compared with a pre-determined second threshold to detect an inrush condition at a third time instance. The frequency contents or detail coefficients are analyzed in this step to obtain information in relation to detection of an inrush condition. If the value of the detail coefficients are consecutively low for four samples, then it is classified as inrush occurrence in that cycle, i.e., detail_coeff(n), detail_coeff(n-1), detail_coeff(n-2) and detail_coeff(n-3) should all be approximately zero. Since presence of noise cannot be completely avoided, a very small threshold value is used for comparison instead of absolute zero. Hence, the second threshold corresponds to a near zero value.

After detection of inrush condition for subsequent cycles of the current signal, the inrush condition is detected based on whether the average value of latest four samples of detail_coeffs is less than a pre-determined threshold. This is to account for a possible saturation of the Current Transformers due to inrush current. In an embodiment, the detected inrush output signal is reset on detection of a normal current signal for a pre-determined number of cycles. Wherein the normal current signal is a signal without any deviation. That is, the inrush output signal is reset subsequent to a predefined number of current signals when the error is less than or equal to the first threshold. This gives a cycle by cycle information on the presence of inrush. The output information or output signal from the inrush detection module 180 can be provided to the protection logic 140.

As shown in step 270 the slope or rate of change in the sampled values occurring between the inception of deviation and the detected inrush condition is computed. Which means that, the rate of change in sampled values that occurred succeeding the second time instance and preceding the third time instance is computed. As mentioned herein above the second time instance corresponds to the instance of inception of deviation and the third time instance corresponds to the instance when inrush condition is detected. Whenever the inrush condition is detected, the slope of the current waveform with previous current samples is computed as shown in the exemplary equation below with current samples n-2 and n-4:

$$slope(n) = current(n-2) - current(n-4)\ldots\ldots\ldots\ldots\ldots\ldots\ldots\ldots\ldots\ldots\ldots\ldots\ldots\ldots\ldots\ldots\ldots\ldots\ldots\ldots\ldots(3)$$

As shown in step 280, the CT saturation is detected on exceeding a predefined third threshold value by the computed rate of change in the sampled values. If the absolute value of the slope exceeds the third threshold, then it is detected as a case of CT saturation during inrush. The third threshold is a pre-determined value obtained from characteristic slope of any current signal exhibiting CT saturation. The output information regarding the CT saturation from the CT saturation detection module 190 is provided to the Protection logic 140.

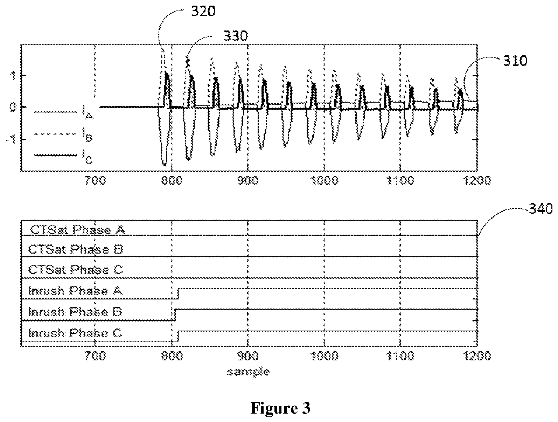

Figure 3 illustrates output waveform representation of CT output for a three phase system and a graph indicating high inrush condition and low CT saturation in all the three phases. The current in three phases are indicated as current $I_A$ 310, $I_B$ 320 and Ic 330. As shown in Figure 3, the current signals in all the three phases are exhibiting an inrush condition which is further reflected in the graph 340 showing a high for Inrush Phase A, Inrush Phase B and Inrush Phase C. Also the graph 340 indicates non-existence of CT saturation while inrush is existing.

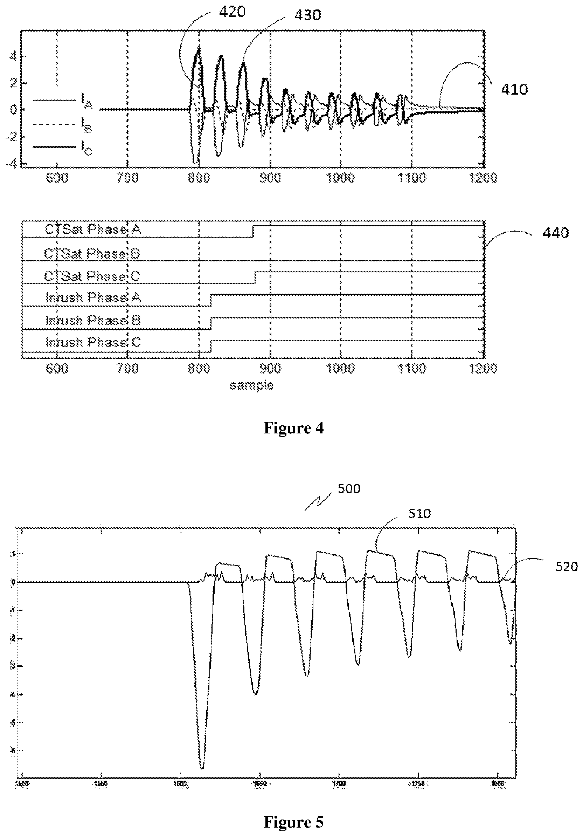

Figure 4 illustrates output waveform representation of CT output for a three phase system and a graph indicating high inrush condition in all three phases and high CT saturation in two of the phases. The current in three phases are indicated as current $I_A$ 310, $I_B$ 320 and Ic 330. As shown in Figure 4, the current signals in all the three phases are exhibiting an inrush condition which is further reflected in the graph 440 showing a high for Inrush Phase A, Inrush Phase B and Inrush Phase C. Additionally, for phases with current $I_A$ and Ic the CT saturation has occurred depicting a current signal with a slope characteristic of a condition of CT saturation. Hence the graph 440 indicates a high for phases with current $I_A$ and $I_C$.

Figure 5 illustrates a graph representing frequency contents present during an inrush condition. The graph is indicated as 500, showing the current signal 520 during an inrush condition and the frequency contents 520 that correspond to the current signal. The graph 50 indicates the decaying nature of the frequency contents or detail coefficients to a near zero value when an inrush condition is existing.

This written description uses examples to describe the subject matter herein, including the best mode, and also to enable any person skilled in the art to make and use the subject matter. The patentable scope of the subject matter is defined by the claims, and may include other examples that occur to those skilled in the art. Such other examples are intended to be within the scope of the claims if they have structural elements that do not differ from the literal language of the claims, or if they include equivalent structural elements with insubstantial differences from the literal language of the claims.

**Claims**

1. A method for detecting inrush and saturation in a current transformer with an intelligent electronic device (IED), wherein the IED is coupled to the current transformer and the current transformer is connected for measurement of current in a circuit having an electrical equipment protected by the IED, the method steps being performed in the IED, the method comprising:

   acquiring a current signal from the current transformer and converting the current signal into sampled values (210);
   computing an estimated sampled value of the current signal at a first time instance using the sampled values of the current signal (220);
   determining an error by obtaining difference between the estimated sampled value of the current signal at the first time instance and a sampled value of current signal at the first time instance from the sampled values (230);
   comparing the error to a first threshold value to identify a deviation in the sampled value of the current signal and a second time instance corresponding to an inception of the deviation (240);
   applying wavelet filtering on the sampled values occurring after the second time instance to obtain one or more frequency contents occurring in the sampled value occurring after the inception of deviation (250);
   comparing the one or more obtained frequency contents with a second threshold to detect an inrush condition at a third time instance (260);
   computing rate of change in the sampled values occurring between the inception of deviation and the detected inrush condition (270); and
   detecting a saturation in the current transformer on exceeding a predefined third threshold value by the computed rate of change in the sampled values (280).

2. The method as claimed in claim 1, wherein computing an estimated sampled value of the current signal (220) comprises applying regression using a plurality of pre-calculated regression coefficients.

3. The method as claimed in claim 2, wherein the plurality of predetermined regression coefficients are estimated based on a unit sine wave at a sampling frequency of the CT output.

4. The method as claimed in claim 1, wherein the first threshold is at least one of a predefined first threshold and the deviation is identified when the error exceeds the first threshold.

5. The method as claimed in claim 1, wherein the second threshold is at least one of a predefined second threshold to detect the inrush condition.

6. The method as claimed in claim 1, wherein the wavelet filtering (250) is done using a finite impulse response high pass filter having predefined wavelet coefficients.

7. The method as claimed in claim 1, wherein the third threshold is at least one of a predefined third threshold to detect the saturation in the current transformer.

8. The method as claimed in claim 1, further comprising resetting the detected inrush condition signal subsequent to a predefined number of current signals when the error is less than or equal to the first threshold.

9. An Intelligent Electronic Device (IED) (100) with an Inrush condition and CT saturation detection module (130), wherein the IED (100) is coupled to a current transformer (110) and the current transformer (110) is connected for measurement of current in a circuit having an electrical equipment protected by the IED (100), the Inrush condition and CT saturation detection module (130) comprising:

   an analog to digital converter (150) to convert the received current signal from the CT into sampled values of current;

a deviation identification module (160) to compute an estimated sampled value of the current signal at a first time instance using the sampled values of the current signal, determine an error by obtaining difference between the estimated sampled value of the current signal at the first time instance and a sampled value of current signal at the first time instance from the sampled values and compare the error to a first threshold value to identify a deviation in the sampled value of the current signal and a second time instance corresponding to an inception of the deviation;

a wavelet filtering module (170) to apply wavelet filtering on the sampled values occurring after the second time instance to obtain one or more frequency contents occurring in the sampled value occurring after the inception of deviation;

an inrush detection module (180) to compare the one or more obtained frequency contents with a second threshold to detect an inrush condition at a third time instance; and

a CT saturation detection module (190) to compute rate of change in the sampled values occurring between the inception of deviation and the detected inrush condition and detect a saturation in the current transformer on exceeding a predefined third threshold value by the computed rate of change in the sampled values.

**10.** The IED as claimed in claim 9, further comprising a protection logic (140) to receive the output from the Inrush detection module (180) and CT saturation detection module (190).

**Patentansprüche**

**1.** Verfahren zum Detektieren von Stromstoß und Sättigung in einem Stromtransformator mit einer intelligenten elektronischen Vorrichtung (IED), wobei die IED mit dem Stromtransformator gekoppelt ist und der Stromtransformator zur Strommessung in einer Schaltung angeschlossen ist, die eine elektrische Ausrüstung aufweist, die durch die IED geschützt wird, wobei die Verfahrensschritte in der IED durchgeführt werden, wobei das Verfahren Folgendes umfasst:

Erfassen eines Stromsignals vom Stromtransformator und Umsetzen des Stromsignals in Abtastwerte (210);

Berechnen eines geschätzten Abtastwertes des Stromsignals zu einem ersten Zeitpunkt unter Verwendung der Abtastwerte des Stromsignals (220);

Bestimmen eines Fehlers durch Erhalten einer Differenz zwischen dem geschätzten Abtastwert des Stromsignals zum ersten Zeitpunkt und einem Abtastwert des Stromsignals zum ersten Zeitpunkt aus den Abtastwerten (230);

Vergleichen des Fehlers mit einem ersten Schwellenwert, um eine Abweichung des Abtastwertes des Stromsignals und einen zweiten Zeitpunkt, der einem Beginn der Abweichung entspricht, zu identifizieren (240);

Anwenden einer Wavelet-Filterung auf die Abtastwerte, die nach dem zweiten Zeitpunkt auftreten, um einen oder mehrere Frequenzanteile zu erhalten, die in dem Abtastwert auftreten, der nach dem Beginn der Abweichung auftritt (250);

Vergleichen des einen oder der mehreren erhaltenen Frequenzanteile mit einem zweiten Schwellenwert, um einen Stromstoßzustand zu einem dritten Zeitpunkt zu detektieren (260);

Berechnen der Änderungsrate der Abtastwerte, die zwischen dem Beginn der Abweichung und dem detektierten Stromstoßzustand auftreten (270); und

Detektieren einer Sättigung im Stromtransformator aufgrund des Überschreitens eines vorgegebenen dritten Schwellenwertes durch die berechnete Änderungsrate der Abtastwerte (280).

**2.** Verfahren nach Anspruch 1, wobei das Berechnen eines geschätzten Abtastwertes des Stromsignals (220) das Anwenden einer Regression unter Verwendung mehrerer vorab berechneter Regressionskoeffizienten umfasst.

**3.** Verfahren nach Anspruch 2, wobei die mehreren vorgegebenen Regressionskoeffizienten auf der Grundlage einer Einheitssinuswelle bei einer Abtastfrequenz des CT-Ausgangs geschätzt werden.

**4.** Verfahren nach Anspruch 1, wobei der erste Schwellenwert mindestens einer eines vorab definierten ersten Schwellenwertes ist und die Abweichung identifiziert wird, wenn der Fehler den ersten Schwellenwert überschreitet.

**5.** Verfahren nach Anspruch 1, wobei der zweite Schwellenwert mindestens einer eines vorab definierten zweiten Schwellenwertes, um den Stromstoßzustand zu detektieren, ist.

**6.** Verfahren nach Anspruch 1, wobei die Wavelet-Filterung (250) unter Verwendung eines Hochpassfilters mit begrenzter Impulsantwort, der vorab definierte Wavelet-Koeffizienten aufweist, durchgeführt wird.

7. Verfahren nach Anspruch 1, wobei der dritte Schwellenwert mindestens einer eines vorab definierten dritten Schwellenwertes, um die Sättigung im Stromtransformator zu detektieren, ist.

8. Verfahren nach Anspruch 1, das ferner das Zurücksetzen des Signals für einen detektierten Stromstoßzustand auf eine vorab definierte Anzahl von Stromsignalen folgend, wenn der Fehler kleiner oder gleich dem ersten Schwellenwert ist, umfasst.

9. Intelligente elektronische Vorrichtung (IED) (100) mit einem Stromstoßzustands-und-CT-SättigungsDetektionsmodul (130), wobei die IED (100) mit einem Stromtransformator (110) gekoppelt ist und der Stromtransformator (110) zur Strommessung in einer Schaltung angeschlossen ist, die eine elektrischen Ausrüstung aufweist, die durch die IED (100) geschützt wird, wobei das Stromstoßzustands-und-CT-SättigungsDetektionsmodul (130) Folgendes umfasst:

einen Analog/Digital-Umsetzer (150), um das empfangene Stromsignal vom CT in Abtaststromwerte umzusetzen;

ein Abweichungsidentifizierungsmodul (160), um unter Verwendung der Abtastwerte des Stromsignals einen geschätzten Abtastwert des Stromsignals zu einem ersten Zeitpunkt zu berechnen, durch Erhalten einer Differenz zwischen dem geschätzten Abtastwert des Stromsignals zum ersten Zeitpunkt und einem Abtastwert des Stromsignals zum ersten Zeitpunkt aus den Abtastwerten einen Fehler zu bestimmen und den Fehler mit einem ersten Schwellenwert zu vergleichen, um eine Abweichung des Abtastwertes des Stromsignals und einen zweiten Zeitpunkt, der einem Beginn der Abweichung entspricht, zu identifizieren;

ein Wavelet-Filtermodul (170), um auf die Abtastwerte, die nach dem zweiten Zeitpunkt auftreten, eine Wavelet-Filterung anzuwenden, um einen oder mehrere Frequenzanteile zu erhalten, die in dem Abtastwert auftreten, die nach dem Beginn der Abweichung auftritt;

ein Stromstoßdetektionsmodul (180), um den einen oder die mehreren erhaltenen Frequenzanteile mit einem zweiten Schwellenwert zu vergleichen, um einen Stromstoßzustand zu einem dritten Zeitpunkt zu detektieren; und

ein CT-Sättigungsdetektionsmodul (190), um eine Änderungsrate der Abtastwerte, die zwischen dem Beginn der Abweichung und dem detektierten Stromstoßzustand auftreten, zu berechnen und aufgrund einer Überschreitung eines vorab definierten dritten Schwellenwertes durch die berechnete Änderungsrate der Abtastwerte eine Sättigung des Stromtransformators zu detektieren.

10. IED nach Anspruch 9, die ferner eine Schutzlogik (140), um den Ausgang von dem Stromstoßdetektionsmodul (180) und dem CT-Sättigungsmodul (190) zu empfangen, umfasst.

**Revendications**

1. Procédé pour détecter l'appel de courant et la saturation dans un transformateur de courant avec un dispositif électronique intelligent, IED, où l'IED est couplé au transformateur de courant et le transformateur de courant est connecté pour la mesure du courant dans un circuit ayant un équipement électrique protégé par l'IED, les étapes du procédé étant exécutées dans l'IED, le procédé comprenant les étapes suivantes :

acquérir un signal de courant depuis le transformateur de courant et convertir le signal de courant en valeurs échantillonnées (210) ;

calculer une valeur échantillonnée estimée du signal de courant à une première occurrence temporelle en utilisant les valeurs échantillonnées du signal de courant (220) ;

déterminer une erreur en obtenant la différence entre la valeur échantillonnée estimée du signal courant à la première occurrence temporelle et une valeur échantillonnée du signal courant à la première occurrence temporelle à partir des valeurs échantillonnées (230) ;

comparer l'erreur à une première valeur de seuil pour identifier une déviation dans la valeur échantillonnée du signal de courant et une deuxième occurrence temporelle correspondant à un début de la déviation (240) ;

appliquer un filtrage par ondelettes sur les valeurs échantillonnées se produisant après la deuxième occurrence temporelle pour obtenir un ou plusieurs contenus de fréquence se produisant dans la valeur échantillonnée se produisant après le début de la déviation (250) ;

comparer les un ou plusieurs contenus de fréquence obtenus avec un deuxième seuil pour détecter une condition d'appel à une troisième occurrence temporelle (260) ;
calculer le taux de changement dans les valeurs échantillonnées se produisant entre le début de la déviation et la condition d'appel détectée (270) ; et
détecter une saturation dans le transformateur de courant lors du dépassement d'une troisième valeur de seuil prédéfinie par le taux de changement calculé dans les valeurs échantillonnées (280).

**2.** Procédé tel que revendiqué dans la revendication 1, dans lequel le calcul d'une valeur échantillonnée estimée du signal de courant (220) comprend l'application d'une régression utilisant une pluralité de coefficients de régression précalculés.

**3.** Procédé tel que revendiqué dans la revendication 2, dans lequel la pluralité de coefficients de régression prédéterminés sont estimés sur la base d'une onde sinusoïdale unitaire à une fréquence d'échantillonnage de la sortie du CT.

**4.** Procédé tel que revendiqué dans la revendication 1, dans lequel le premier seuil est au moins un premier seuil prédéfini et la déviation est identifiée lorsque l'erreur dépasse le premier seuil.

**5.** Procédé tel que revendiqué dans la revendication 1, dans lequel le deuxième seuil est au moins l'un d'un deuxième seuil prédéfini pour détecter la condition d'appel.

**6.** Procédé tel que revendiqué dans la revendication 1, dans lequel le filtrage en ondelettes (250) est effectué en utilisant un filtre passe-haut à réponse impulsionnelle finie ayant des coefficients d'ondelettes prédéfinis.

**7.** Procédé tel que revendiqué dans la revendication 1, dans lequel le troisième seuil est au moins l'un d'un troisième seuil prédéfini pour détecter la saturation dans le transformateur de courant.

**8.** Procédé tel que revendiqué dans la revendication 1, comprenant en outre de réinitialiser le signal de condition d'appel détecté à la suite d'un nombre prédéfini de signaux de courant lorsque l'erreur est inférieure ou égale au premier seuil.

**9.** Dispositif électronique intelligent, IED, (100) avec un module de détection de saturation de CT et de condition d'appel (130), où l'IED (100) est couplé à un transformateur de courant (110) et le transformateur de courant (110) est connecté pour mesurer le courant dans un circuit ayant un équipement électrique protégé par l'IED (100), le module de détection de saturation de CT et de condition d'appel (130) comprenant :

un convertisseur analogique-numérique (150) pour convertir le signal de courant reçu du CT en valeurs échantillonnées de courant ;
un module d'identification de déviation (160) pour calculer une valeur échantillonnée estimée du signal de courant à une première occurrence temporelle en utilisant les valeurs échantillonnées du signal de courant, déterminer une erreur en obtenant la différence entre la valeur échantillonnée estimée du signal de courant à la première occurrence temporelle et une valeur échantillonnée du signal de courant à la première occurrence temporelle à partir des valeurs échantillonnées, et comparer l'erreur à une première valeur de seuil pour identifier une déviation dans la valeur échantillonnée du signal de courant et une deuxième occurrence temporelle correspondant à un début de la déviation ;
un module de filtrage par ondelettes (170) pour appliquer un filtrage par ondelettes sur les valeurs échantillonnées se produisant après la deuxième occurrence temporelle pour obtenir un ou plusieurs contenus de fréquence se produisant dans la valeur échantillonnée se produisant après le début de la déviation ;
un module de détection d'appel (180) pour comparer les un ou plusieurs contenus de fréquence obtenus avec un deuxième seuil pour détecter une condition d'appel à une troisième occurrence temporelle ; et
un module de détection de saturation du CT (190) pour calculer le taux de changement dans les valeurs échantillonnées se produisant entre le début de la déviation et la condition d'appel détectée, et détecter une saturation dans le transformateur de courant lors du dépassement d'une troisième valeur de seuil prédéfinie par le taux de changement calculé dans les valeurs échantillonnées.

**10.** IED tel que revendiqué dans la revendication 9, comprenant en outre une logique de protection (140) pour recevoir la sortie du module de détection d'appel de courant (180) et du module de détection de saturation de CT (190).

**Figure 1**

EP 3 560 054 B1

200

| Receiving sampled values of a current signal from a current transformer (CT) | 210 |

| Computing an estimated sampled value of the current signal at a first time instance | 220 |

| Determining an error from the difference between estimated sampled value and a sampled value of current signal at the first time instance | 230 |

| Identifying a deviation at a second time instance based on comparing the error to a first threshold value | 240 |

| Applying wavelet filtering on the sampled values occurring after the second time instance to obtain frequency contents. | 250 |

| Comparing the frequency contents with a second threshold to detect an inrush condition at a third time instance. | 260 |

| Computing rate of change in sampled values occurring between the inception of deviation and the detected inrush condition | 270 |

| Detecting CT saturation on exceeding a predefined third threshold value by the computed rate of change in the sampled values. | 280 |

**Figure 2**

11

Figure 3

**Figure 4**

**Figure 5**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2005094344 A1
- US 2011241654 A1
- WO 9313581 A1
- US 6072310 A
- US 6442010 B